(19) Europäisches Patentamt / European Patent Office / Office européen des brevets

(11) **EP 2 979 363 B1**

(12) **FASCICULE DE BREVET EUROPEEN**

(45) Date de publication et mention
de la délivrance du brevet:
**04.10.2017 Bulletin 2017/40**

(21) Numéro de dépôt: **14718668.8**

(22) Date de dépôt: **25.03.2014**

(51) Int Cl.:
***H03K 19/177*** *(2006.01)*

(86) Numéro de dépôt international:
**PCT/FR2014/050692**

(87) Numéro de publication internationale:
**WO 2014/154996 (02.10.2014 Gazette 2014/40)**

(54) **DISPOSITIF D'INTERCONNEXION PROGRAMMABLE**

PROGRAMMIERBARE VERBINDUNGSVORRICHTUNG

PROGRAMMABLE INTERCONNECTION DEVICE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **28.03.2013 FR 1352827**

(43) Date de publication de la demande:
**03.02.2016 Bulletin 2016/05**

(73) Titulaire: **Nanoxplore**
**75016 Paris (FR)**

(72) Inventeur: **LEPAPE, Olivier**
**F-75016 Paris (FR)**

(74) Mandataire: **Underwood, Nicolas Patrick et al**
**Cabinet Beau de Loménie**
**158, rue de l'Université**
**75340 Paris Cedex 07 (FR)**

(56) Documents cités:
**US-A- 5 742 181      US-A- 6 014 509
US-B1- 6 289 494      US-B1- 7 028 281**

EP 2 979 363 B1

## Description

Arrière-plan de l'invention

La présente invention concerne le domaine des circuits intégrés et porte plus particulièrement sur l'architecture d'un dispositif d'interconnexion programmable et sur l'application d'un tel dispositif dans des circuits logiques programmables tels que des composants FPGA (« field-programmable gate array » en anglais).

Un dispositif (ou système) d'interconnexion programmable comprend un circuit électronique permettant de réaliser des fonctions d'interconnexion de N sorties vers M entrées (N et M étant des entiers naturels). Un tel dispositif d'interconnexion programmable peut ainsi se connecter entre les N sorties d'un premier ensemble de circuits électroniques et les M entrées d'un second ensemble de circuits électroniques de façon à réaliser par programmation la connexion logique d'un sous-ensemble des M sorties du premier ensemble de circuits avec un sous-ensemble des N entrées du second ensemble de circuits.

La fonction d'interconnexion attribue à chaque entrée du second ensemble une sortie unique du premier ensemble. Il n'y a pas de limitation en revanche sur le nombre d'entrées du second ensemble pouvant recevoir une même sortie du premier ensemble.

De façon connue, un circuit FPGA est un circuit intégré logique comprenant des blocs logiques élémentaires librement assemblables. Ces blocs logiques sont interconnectés ensemble de manière définitive ou réversible par programmation, afin de réaliser la ou les fonctions voulues.

Un même circuit FPGA peut ainsi être utilisé pour différentes applications électroniques. Après programmation, le circuit FPGA se comporte comme un circuit intégré spécialisé (« ASICS ») réalisant la ou les fonctions logiques établies par la programmation.

Un bloc logique peut par exemple inclure une table de correspondance (LUT ou « Look-Up-Table ») et une bascule (« Flip-Flop »).

Un circuit FPGA peut être organisé en un grand nombre de blocs fonctionnels, chaque bloc fonctionnel comprenant une pluralité de blocs logiques élémentaires de façon à pouvoir réaliser des fonctions particulières. Ces blocs fonctionnels sont, au même titre que les blocs logiques élémentaires, connectés entre eux par une matrice de routage configurable par programmation. Cette matrice permet la reconfiguration à volonté du composant FPGA.

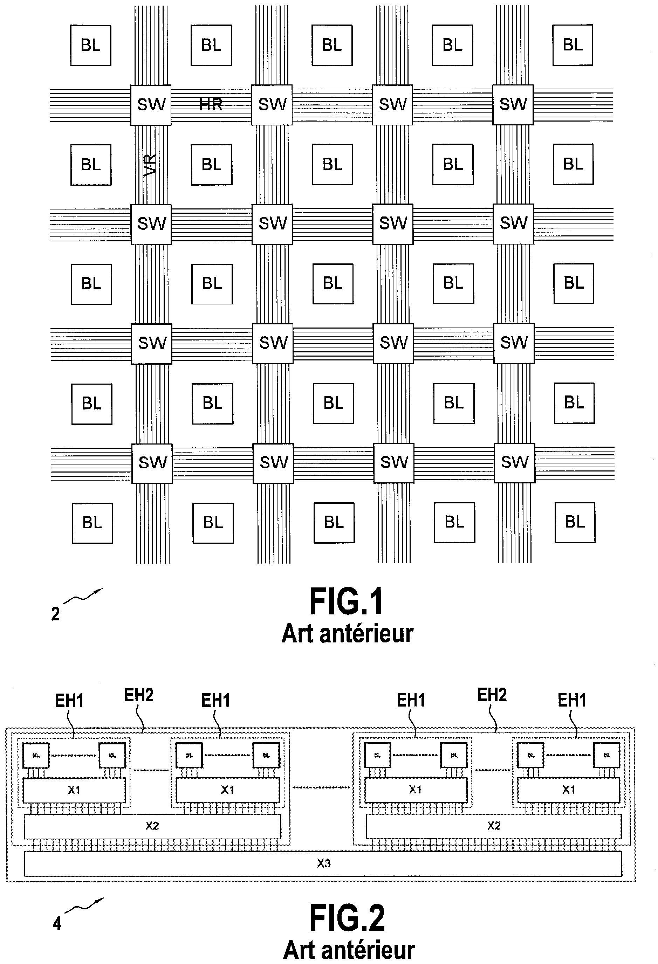

La **figure 1** représente schématiquement une architecture classique dite « Manhattan » (ou 2D) d'un circuit d'interconnexion programmable 2 dans lequel des blocs logiques BL sont positionnés régulièrement en rangées et en colonnes. Les interconnexions programmables sont réalisées par des ensembles de pistes conductrices horizontales HR et verticales VR, et par des blocs d'aiguillage SW aptes à réaliser des connexions programmables entres lesdites pistes conductrices. Les blocs d'aiguillage SW sont disposés régulièrement en rangées et colonnes de façon à être entrelacés avec les rangées et colonnes des blocs logiques BL.

Le type de réseau de la figure 1 nécessite cependant un grand nombre de conducteurs et impose donc un encombrement important pour assurer une efficacité suffisante. On entend par « efficacité », la faculté d'une structure à pouvoir reproduire par programmation et sans blocage les interconnexions d'une application donnée quelle que soit sa complexité.

Un réseau « Manhattan » devient peu efficace et encombrant à mesure que le nombre de blocs logiques augmente. S'il est vrai que les temps de propagation dans ces réseaux sont en général convenables pour des blocs logiques spatialement proches, il faut toutefois noter que ces temps de propagation sont de moins en moins satisfaisants lorsque la distance entre les blocs logiques augmente, ceci s'expliquant en particulier par le nombre croissant de blocs d'aiguillage SW qu'il faut traverser pour transporter un signal.

La **figure 2** représente une architecture connue d'un autre circuit d'interconnexion programmable 4 dans lequel les blocs logiques BL sont regroupés en plusieurs ensembles EH1 de premier niveau hiérarchique. Chaque ensemble EH1 constitue par exemple un bloc fonctionnel.

Les blocs logiques BL sont ici interconnectés par un réseau de matrices X1 dénommées « crossbars », ces derniers permettant la réalisation des interconnexions entre les blocs logiques BL et les entrées/sorties du premier niveau hiérarchique.

Les ensembles EH1 du premier niveau hiérarchique sont regroupés en plusieurs ensembles EH2 de second niveau hiérarchique. Les ensembles EH1 sont interconnectés ensemble par un réseau de crossbars X2 permettant la réalisation des connexions entre les ensembles EH1 et les entrées/sorties du second niveau hiérarchique. Le circuit 4 peut comprendre autant de niveaux hiérarchiques que nécessaire.

L'architecture du circuit 4 est plus efficace et présente un encombrement inférieur vis-à-vis de la structure « Manhattan » représentée en figure 1 lorsque le nombre de blocs logiques BL devient très important.

Les caractéristiques de temps de propagation du circuit 4 sont par ailleurs satisfaisantes au sein d'un même niveau hiérarchique mais sont fortement pénalisées par le fait que les connexions entre deux ensembles distincts mais de même niveau hiérarchique doivent passer par le niveau hiérarchique supérieur. Ainsi, deux blocs logiques BL peuvent être spatialement proches sur la puce mais temporellement éloignés en termes de propagation de signal en raison de l'appartenance des deux blocs logiques à des ensembles hiérarchiques distincts.

Il existe donc un besoin pour un dispositif d'interconnexion programmable présentant des performances satisfaisantes, notamment en termes d'efficacité, de temps de propagation de signal et d'encombrement sur la puce.

Le document US 6 289 494 B1 daté du 11 septembre 2001 divulgue une puce logique utile pour l'émulation et le prototypage de circuits intégrés. La puce logique comprend une pluralité d'éléments logiques qui sont divisés en une pluralité de sous-groupes d'éléments logiques. La puce logique comporte également des interconnexions afin de faire des interconnexions dans les sous-groupes d'éléments logiques.

Le document US 7 028 281 B1 daté du 11 avril 2006 divulgue une architecture de type FPGA incorporant des registres dans des blocs logiques.

Le document US 5 742 181 A daté du 21 avril 1998 divulgue une architecture de type FPGA comprenant une structure d'interconnexion.

Le document US 6 014 509 A daté du 11 janvier 2000 divulgue un dispositif FPGA comprenant un accès à des cellules voisines orthogonales et diagonales.

Objet et résumé de l'invention

A cet effet, la présente invention concerne un dispositif d'interconnexion programmable comprenant :

- au moins une première rangée de g blocs fonctionnels, chaque bloc fonctionnel comprenant une pluralité d'entrées, une pluralité de sorties et une pluralité de fonctions numériques ;
- au moins une deuxième rangée de n cellules d'interconnexion programmables, la deuxième rangée étant adjacente à la première rangée ;
- une pluralité de connexions dites horizontales, chaque connexion horizontale reliant une cellule d'interconnexion programmable respective de la deuxième rangée avec uniquement une autre cellule d'interconnexion programmables de la deuxième rangée, les cellules reliées ensemble par la connexion horizontale n'étant pas adjacentes l'une vis-à-vis de l'autre dans la deuxième rangée; et
- une pluralité de faisceaux de connexions, chaque faisceau comportant au moins deux connexions dites transverses reliant une même cellule d'interconnexion programmable avec respectivement un ensemble de blocs fonctionnels de la première rangée adjacents entre eux dont l'un des blocs est situé en correspondance avec ladite cellule ;

dans lequel l'ensemble des cellules d'interconnexion programmables sont aptes à interconnecter entre elles les entrées et les sorties de chaque bloc fonctionnel de la première rangée avec respectivement les sorties et les entrées de tous les autres blocs fonctionnels de la première rangée au moyen des connexions horizontales et transverses.

Le dispositif d'interconnexion programmable de l'invention est avantageux en ce qu'il offre une efficacité optimale pour un encombrement limité et un temps de propagation faible même lorsque le nombre de blocs fonctionnels est important. Le dispositif permet d'interconnecter ensemble tous les blocs fonctionnels d'une même rangée via seulement les connexions horizontales et transverses (ou, le cas échéant, via seulement des connexions transverses) sans que les temps de propagation souffrent d'un effet de seuil indésirable comme décrit en référence à la figure 2. Deux blocs fonctionnels spatialement proches dans une même rangée peuvent être connectés ensemble via un minimum de connexions et un minimum de longueur de conducteur.

L'architecture du dispositif selon l'invention offre un compromis optimal entre efficacité, encombrement et temps de propagation.

Dans un mode de réalisation particulier, la condition n=g est satisfaite.

Dans une variante de ce mode particulier :

- les blocs fonctionnels dits $F_i$ de la première rangée sont tels que chaque $F_i$ est disposé de façon à être adjacent à $F_{i-1}$ et $F_{i+1}$, i étant un entier naturel allant de 1 à g ;
- les cellules d'interconnexion programmables dites $M_j$ de la deuxième rangée sont telles que chaque $M_j$ est disposée de façon à être adjacente à $M_{j-1}$ et $M_{j+1}$, j'étant un entier allant de 1 à n, dans lequel $M_j$ et $F_i$ sont positionnés en vis-à-vis l'un de l'autre lorsque i=j ;
- chaque connexion horizontale relie une cellule d'interconnexion programmable $M_j$ respective de la deuxième rangée avec uniquement la cellule d'interconnexion programmable voisine $M_{j+d1}$ de la deuxième rangée pour j allant de 1 à n-d1 ;
- chaque faisceau de connexions relie au moyen des connexions transverses une cellule d'interconnexion programmable $M_j$ respective de la deuxième rangée avec respectivement chacun des blocs fonctionnels $F_{j-d2}$ à $F_{j+d3}$ de la première rangée ou, le cas échéant, avec seulement ceux parmi ces blocs qui existent ; et
- d1, d2 et d3 sont des entiers tels que : $d2 \geq 1$, $d3 \geq 1$, $1 < d1 \leq d2 +d3 +1$ et $g > d2 + d3$.

On comprendra qu'il n'est pas obligatoire que d2=d3 bien que cela facilite la programmation du dispositif d'interconnexion programmable.

Dans une variante particulière, la condition suivante est satisfaite :

$$d1 = 2, d2 = d3 = 1.$$

Dans une variante particulière, le dispositif d'interconnexion programmable comprend une pluralité de connexions dite locales reliant une cellule d'interconnexion $M_j$ respective de la deuxième rangée avec uniquement la cellules d'interconnexion $M_{j+d4}$ de la deuxième rangée pour j allant de 1 à n-d4, d4 étant tel que $1 \leq$

d4 < d1.

Ces connexions locales permettent avantageusement d'optimiser le parcours (i.e. le routage) nécessaire dans le réseau pour connecter ensemble deux blocs fonctionnels F, et donc de réduire encore davantage les temps de propagation dans le dispositif d'interconnexion programmable.

L'ajout des connexions locales offrent en outre davantage de flexibilité au routage des interconnexions dans le dispositif puisque plusieurs options de routage sont ainsi possibles.

Dans un exemple de mise en oeuvre particulier, d4=1 ce qui permet avantageusement de simplifier l'algorithme de programmation du réseau d'interconnexion du dispositif 6. Ce choix permet notamment d'éviter des allers retours indésirables dans la ou les deuxièmes rangées de cellules qui pourraient s'avérer nécessaires pour interconnecter ensemble deux blocs fonctionnels lorsque d4>1 (avec toujours d4<d1).

Dans un mode de réalisation particulier, d1 = 5, d2 = d3 = 2 et d4 = 1.

Dans un autre mode de réalisation, d1 = 7, d2 = d3 = 3 et d4 = 1.

Dans un mode de réalisation particulier, le dispositif d'interconnexion programmable comprend une pluralité de dites premières et deuxièmes rangées disposées en alternance, le dispositif comprenant en outre une pluralité de connexions dites verticales reliant chaque cellule d'interconnexion programmable $M_j$ d'une première rangée avec les cellules $M_j$ correspondantes d'une première rangée adjacente.

Dans une variante particulière où d2 = d3, le dispositif d'interconnexion programmable comprend :

- une première connexion transverse additionnelle combinée à chacune des connexions transverses reliant respectivement les cellules d'interconnexion programmables $M_j$ et les blocs fonctionnels $F_i$, pour chaque couple [i, j] avec i et j allant chacun de 1 à d2 sauf lorsque (d2 + 1 - i) < j, et
- une deuxième connexion transverse additionnelle combinée à chacune des connexions transverses reliant respectivement les cellules d'interconnexion programmables $M_j$ et les blocs fonctionnels $F_i$, pour chaque couple [i, j] avec i et j allant chacun de n-d3+1 à n sauf lorsque (d3 - 1 - n + i) < (n - j),

de sorte qu'un nombre constant de connexion transverses relie toutes les cellules d'interconnexion programmables de la deuxième rangée aux blocs fonctionnels de la première rangée.

Il est ainsi possible d'ajouter des connexions transverses supplémentaires à une ou plusieurs cellules M situées aux extrémités de chaque deuxième rangée afin de maintenir un nombre total constant de connexions transverses attribuées à chaque cellule M desdites deuxièmes rangées. On tire ainsi avantageusement partie de toutes les entrées et sorties des cellules M qui étaient initialement non utilisées du fait de l'absence de certains blocs fonctionnels aux extrémités de chaque première rangée.

Dans un mode de réalisation particulier, les blocs fonctionnels comprennent chacun un réseau d'interconnexion programmable permettant de réaliser des connexions par programmation entre les entrées, les sorties et les fonctions numériques dudit bloc fonctionnel.

Dans un mode de réalisation particulier, chacune desdites connexions (i.e. horizontales, transverses et, le cas échéant, locales et/ou verticales) comprend deux fils de connexion permettant respectivement la communication d'une sortie d'une première cellule d'interconnexion programmable vers une entrée d'un bloc fonctionnel ou d'une deuxième cellule d'interconnexion programmable, d'une part, et la communication d'une sortie dudit bloc fonctionnel ou de ladite deuxième cellule d'interconnexion programmable vers une entrée de ladite première cellule d'interconnexion programmable, d'autre part.

La présente invention concerne également un composant FPGA comprenant un dispositif d'interconnexion programmable selon l'un des modes de réalisation ou variantes définis ci-dessus.

Brève description des dessins

D'autres caractéristiques et avantages de la présente invention ressortiront de la description faite ci-dessous, en référence aux dessins annexés qui en illustrent un exemple de réalisation dépourvu de tout caractère limitatif. Sur les figures :

- la figure 1 déjà décrite représente, de manière schématique, l'architecture connue d'un premier circuit d'interconnexion programmable ;
- la figure 2 déjà décrite représente, de manière schématique, l'architecture connue d'un second circuit d'interconnexion programmable ;
- la figure 3 représente, de manière schématique, l'architecture élémentaire d'un dispositif d'interconnexion programmable conforme à un premier mode de réalisation de l'invention ;
- la figure 4 représente, de manière schématique, un dispositif d'interconnexion programmable conforme au premier mode de réalisation de l'invention ;
- les figures 5A et 5B représentent une première variante du premier mode de réalisation représentés en figures 3 et 4 ;
- la figure 6 représente schématiquement une seconde variante du premier mode de réalisation de l'invention ;
- la figure 7 représente un exemple de configuration des connexions réalisées à partir d'une cellule d'interconnexion programmable donnée ; et
- les figures 8A, 8B, 8C et 8D représentent des exemples de structure d'un bloc fonctionnel au sens de l'invention.

Description détaillée de plusieurs modes de réalisation

La présente invention concerne le domaine des circuits intégrés et porte plus particulièrement sur l'architecture d'un dispositif d'interconnexion programmable et sur l'application d'un tel dispositif dans des circuits logiques programmables tels que des composants FPGA.

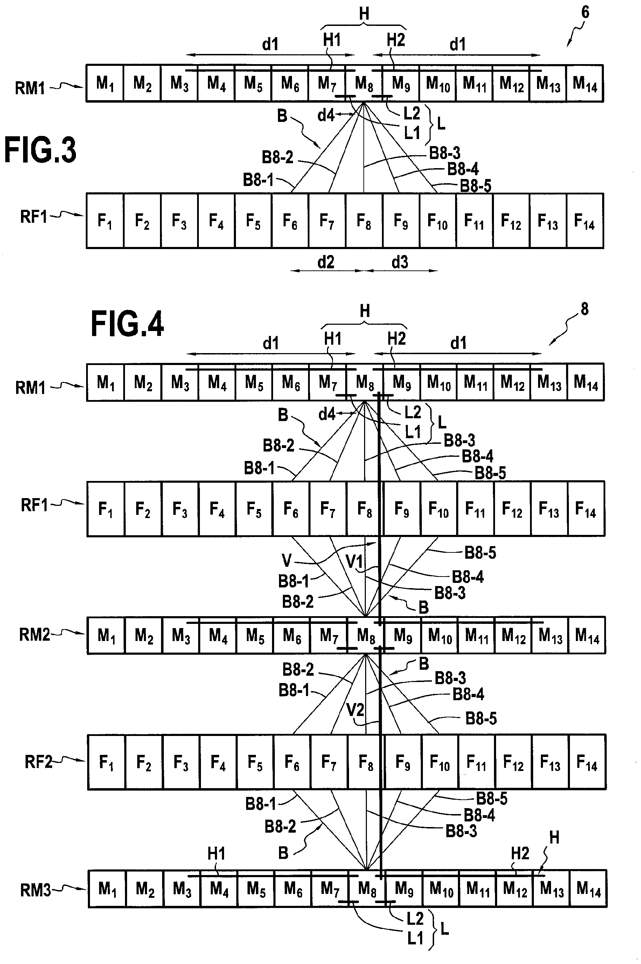

Un premier mode de réalisation de l'invention est à présent décrit en référence aux **figures 3 à 4.**

Plus précisément, la **figure 3** représente la structure élémentaire d'un dispositif d'interconnexion programmable 6 conforme à un premier mode de réalisation de l'invention.

Le dispositif d'interconnexion programmable 6 comprend ici :

- une première rangée RF1 de g blocs fonctionnels notés respectivement $F_i$, le rang i étant un entier allant de 1 à g ; et

- une première rangée RM1 de n cellules d'interconnexion programmables notées respectivement $M_j$, le rang j étant un entier allant de 1 à n.

Dans ce cas particulier, on considère que $g \geq 3$ et $n \geq 2$.

Dans ce document, les blocs fonctionnels et les cellules d'interconnexion programmables sont notés plus généralement F et M respectivement lorsque la référence au rang n'est pas nécessaire.

Les rangées RF1 et RM1 sont disposées ici de façon adjacente l'une de l'autre.

On notera que dans les exemples envisagés dans ce document, les cardinalités n et g des rangées RM1 et RF1 sont égales (n = g). On comprendra toutefois que l'égalité entre n et g n'est pas obligatoire pour mettre en oeuvre l'invention. On considère ici l'exemple où n = g = 14. D'autres valeurs de n et g peuvent naturellement être choisies.

Chaque cellule $M_j$ et chaque bloc $F_i$ possède un rang correspondant respectivement à la valeur de j et i. La distance (ou écart) entre deux cellules d'interconnexion programmables $M_j$ (respectivement entre deux blocs fonctionnels $F_i$) d'une même rangée est la différence entre le rang le plus élevé et le rang le moins élevé des deux cellules d'interconnexion programmables (respectivement des deux blocs fonctionnels).

Seules une rangée de cellules d'interconnexion programmables M et une rangée de blocs fonctionnels F ont ici été représentées. On comprendra toutefois au vu notamment de la figure 4 qu'un dispositif d'interconnexion programmable au sens de l'invention peut comprendre une pluralité de rangées de cellules M et une pluralité de rangées de blocs fonctionnels F, chaque rangée de blocs F étant positionnée entre deux rangées de cellules M.

Dans ce document, on notera que chaque bloc $F_i$ est disposé de façon à être adjacent à $F_{i-1}$ et $F_{i+1}$ de la même rangée (i étant un entier naturel allant de 1 à g) ou, le cas échéant, de façon à être adjacent à celui parmi $F_{i-1}$ et $F_{i+1}$ qui existe. En effet, au niveau des extrémités de la rangée, $F_1$ et $F_9$ n'ont qu'un seul bloc fonctionnel voisin, à savoir $F_2$ et $F_{g-1}$ respectivement.

De même, chaque cellule $M_j$ est disposée de façon à être adjacente à $M_{j-1}$ et $M_{j+1}$ de la même rangée (j étant un entier naturel allant de 1 à n) ou, le cas échéant, à être adjacente à celle parmi $M_{j-1}$ et $M_{j+1}$ qui existe. En effet, au niveau des extrémités de la rangée, $M_1$ et $M_n$ n'ont qu'une seule cellule d'interconnexion programmable voisine, à savoir $M_2$ et $M_{n-1}$ respectivement.

Une cellule $M_j$ et un bloc fonctionnel $F_i$ sont positionnés en correspondance (i.e. en vis-à-vis) l'un par rapport à l'autre lorsque i=j.

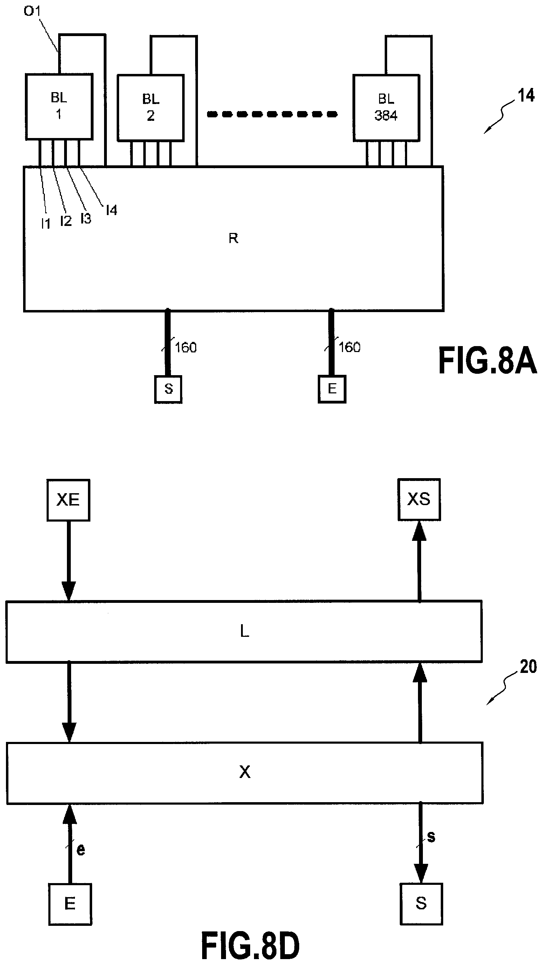

Chaque bloc fonctionnel F comprend des circuits électroniques permettant de réaliser des fonctions logiques. Un bloc F peut prendre la forme d'un bloc fonctionnel logique programmable ou toute autre forme plus adaptée à la réalisation de la ou des fonctions souhaitées (fonction mémoire, traitement de signal (DSP), traitement dédié à un usage spécifique...). Des exemples de structure de blocs fonctionnels au sens de l'invention seront décrits plus en détail ultérieurement en référence aux **figures 8A à 8D.**

Chacun des blocs fonctionnels F peut comprendre :

- une pluralité d'entrées,
- une pluralité de sorties,
- une pluralité de fonctions électroniques numériques, et
- un réseau d'interconnexion programmable apte à interconnecter entre elles les entrées et les sorties desdites fonctions électroniques numériques. Un tel réseau peut comprendre par exemples des matrices de type crossbar ou des réseaux de Clos.

Dans les exemples envisagés ici, chaque bloc fonctionnel F est apte à permuter ses entrées entre elles et à permuter ses sorties entre elles.

Les cellules d'interconnexion programmables M de la rangée RM1 permettent d'assurer les interconnexions dans le dispositif 6 entre les entrées et les sorties des blocs fonctionnels F de la rangée RF1 voisine. Pour ce faire, les cellules M sont configurées pour assurer l'aiguillage des signaux via un ensemble de connexions électriques point à point, ces dernières étant fixes dans le dispositif d'interconnexion programmable. Autrement dit, chacune de ces connexions électriques forme une liaison (électriquement conductrice) réalisée physiquement de façon permanente dans le dispositif d'interconnexion programmable, ces connexions permettant l'échange de signaux de données dans au moins un sens. Chaque connexion peut comprendre une pluralité de fils (ou pistes) de connexion. Les cellules M relient ensemble les connexions électriques appropriées pour faire la liaison entre deux blocs fonctionnels donnés.

Conformément à l'invention, le dispositif d'interconnexion programmable 6 comprend une pluralité de connexions H dites horizontales, chacune de ces connexions reliant une cellule d'interconnexion programmable M respective de la rangée RM1 avec uniquement une autre cellule d'interconnexion programmables M de la même rangé. Les cellules M connectées ensemble par ces connexions horizontales ne sont pas adjacentes les unes aux autres dans la rangée en question. Autrement dit, pour chaque couple de deux cellules M (non adjacentes) connectées ensemble par une connexion horizontale H, il existe au moins une cellule M intermédiaire positionnée entre les deux cellules ainsi connectées. La connexion horizontale ne connecte pas la ou les cellules M intermédiaires aux deux cellules M du couple en question.

Dans l'exemple envisagé ici, la cellule $M_8$ est connectées avec les cellules $M_3$ et $M_{13}$ via respectivement les connexions horizontales H1 et H2 (notées plus généralement H).

Dans cet exemple, les connexions horizontales H sont telles qu'il existe un même nombre de cellules M intermédiaires entre chaque couple de cellules M connectées par les connexions horizontales H.

Dans cet exemple, quatre cellules d'interconnexion programmable sont présentes entre chaque paire de cellules M connectées par une même connexion horizontale H. On considère ici que la distance d1 entre les deux cellules M de chaque paire connectée par une connexion horizontale H est telle que d1=5. D'autres valeurs de d1 peuvent naturellement être choisies.

Chaque connexion horizontale H relie donc une cellule d'interconnexion programmable $M_j$ respective de la rangée RM1 avec uniquement la cellule d'interconnexion programmable voisine $M_{j+d1}$ de la même rangée RM1, pour j allant de 1 à n-d1.

Par souci de clarté, seules les connexions horizontales H reliant la cellule M8 ont été représentées dans la figure 3. On comprendra que le dispositif 6 comprend dans la rangée RM1 toutes les connexions horizontales H pouvant connecter ensemble deux cellules M non adjacentes situées à la distance d1 l'une de l'autre.

Dans l'exemple de la **figure 3,** les cellules d'interconnexion programmables M6, M7, M8 et M9 sont chacune reliées via deux connexions horizontales H aux deux cellules M situées de part et d'autre à la distance d1 dans la rangée RM1. En revanche, au niveau des extrémités de la rangée RM1, les cellules $M_1$ à $M_5$ d'un côté et $M_{10}$ à $M_{14}$ de l'autre ne sont reliées qu'à une seule cellule M non adjacente située à la distance d1. L'unique connexion horizontale reliant M3 correspond par exemple ici à l'une des connexions horizontales reliant M8.

Conformément à l'invention, le dispositif d'interconnexion programmable 6 comprend également une pluralité de faisceaux de connexions B, chaque faisceau comportant au moins deux connexions transverses B reliant une même cellule d'interconnexion programmable M de la rangée RM1 avec respectivement un ensemble de blocs fonctionnels F (de la rangée RF1) adjacents entre eux, l'un de ces blocs F étant situé en correspondance avec ladite cellule M. Les connexions transverses B permettent ainsi de relier chaque cellule M d'une première rangée avec des blocs fonctionnels F d'une seconde rangée adjacente à ladite première rangée.

Un faisceau respectif de connexions transverses B relie chaque cellule M de la rangée RM1 avec des blocs fonctionnels F de la rangée RF1.

Dans ce premier mode de réalisation, la cellule d'interconnexion programmable M8 est connectée via les connexions transverses B8-1, B8-2, B8-3, B8-4 et B8-5 (nommées collectivement B8) avec respectivement les blocs fonctionnels F6, F7, F8, F9 et F10 de la rangée RF1.

Par souci de clarté, seules les connexions transverses B reliant la cellule M8 ont été représentées dans la figure 3. On comprendra toutefois qu'un faisceau de connexions transverses B relie chaque cellule M de la rangée RM1 avec des blocs fonctionnels voisins de la rangée RF1.

Dans une mise en oeuvre particulière de l'invention, chaque faisceau B relie au moyen de connexions transverses distinctes une cellule d'interconnexion programmable Mj respective de la rangée RM1 avec respectivement chacun des blocs fonctionnels $F_{j-d2}$ à $F_{j+d3}$ (j allant de 1 à n) de la rangée RF1 ou, le cas échéant, avec seulement ceux parmi ces blocs qui existent.

En effet, en ce qui concerne les cellules $M_1$ à $M_{d2-1}$ et les cellules $M_{g-d3+1}$ à $M_g$, un ou plusieurs blocs fonctionnels parmi $F_{j-d2}$ à $F_{j+d3}$ n'existent pas. Ces cas particuliers mis à part, chaque faisceau de connexions transverses B permet de connecter une cellule $M_j$ avec le bloc fonctionnel $F_j$ situé en vis-à-vis (i.e. lorsque i=j) ainsi qu'avec les blocs fonctionnels $F_i$ situés à une distance de $F_j$ inférieure ou égale à d2 et d3 respectivement de part et d'autre dans la même rangée (d2 et d3 étant des entiers naturels).

Conformément à l'invention, le dispositif 6 est configuré de sorte que l'ensemble des cellules d'interconnexion programmables M d'une rangée donnée (i.e. ici la rangée RM1) sont aptes par programmation à interconnecter entre elles les entrées et les sorties de chaque bloc fonctionnel F d'une rangée adjacente (i.e. ici la rangée RF1) avec respectivement les sorties et les entrées de tous les autres blocs fonctionnels F de ladite rangée adjacente (RF1) via des connexions horizontales H et transverses B.

Dans le premier mode de réalisation envisagé ici, les conditions suivantes sont par exemple satisfaites :

(a)

$$d2 \geq 1 ;$$

(b)

$$d3 \geq 1 \; ;$$

**(c)**

$$1 < d1 \leq d2 + d3 + 1 \; ;$$

**(d)**

$$g > d2 + d3.$$

Dans cet exemple, n = g donc la condition suivante est également satisfaite :

$$n > d2 + d3.$$

Le respect des conditions (a), (b), (c) et (d) permet par exemple d'interconnecter ensemble à volonté n'importe lesquels des blocs fonctionnels de la rangée RF1 via les connexions horizontales H et transverses B décrites ci-avant.

La **figure 3** représente le cas particulier où d1=5 et d2=d3=2.

On comprendra qu'il n'est pas obligatoire que d2=d3 bien que cela facilite la programmation du dispositif d'interconnexion programmable 6.

Le dispositif d'interconnexion programmable de l'invention est avantageux en ce qu'il offre une efficacité optimale pour un encombrement limité et un temps de propagation faible même lorsque le nombre de blocs fonctionnels est important. Le dispositif permet d'interconnecter ensemble tous les blocs fonctionnels d'une même rangée via seulement les connexions horizontales et transverses (ou, le cas échéant, via seulement des connexions transverses) sans que les temps de propagation souffrent d'un effet de seuil indésirable comme décrit en référence à la figure 2. Deux blocs fonctionnels F spatialement proches dans une même rangée peuvent être connectés ensemble via un minimum de connexions et un minimum de longueur de conducteur.

L'architecture du dispositif selon l'invention offre un compromis optimal entre efficacité, encombrement et temps de propagation.

Pour illustrer la manière dont le dispositif 6 peut être configuré, on considère à présent un exemple où l'on souhaite connecter électriquement une entrée du bloc fonctionnel $F_6$ avec une sortie du bloc fonctionnel $F_{12}$. L'utilisation du faisceau B8 à lui seul ne suffit pas pour connecter ensemble les blocs $F_6$ et $F_{12}$, dans le cas particulier de la figure 3 où d2=d3=2. Aussi, il est nécessaire d'établir la liaison électrique via la cellule $M_{13}$ par exemple. Pour ce faire, la cellule $M_8$ est configurée pour relier ensemble la connexion transverse B8-1 à la connexion horizontale H2. La cellule $M_{13}$ est en outre configurée pour relier cette connexion horizontale H2 avec la connexion transverse (notée B13-2) présente physiquement entre la cellule $M_{13}$ et le bloc fonctionnel $F_{12}$.

Par ailleurs, bien que cela ne soit pas obligatoire, la structure 6 peut en outre comprendre un ensemble de connexions locales L reliant chaque cellule d'interconnexion $M_j$ de la rangée RM1 avec uniquement la cellule d'interconnexion $M_{j+d4}$ de la même rangée RM1, pour j allant de 1 à n-d4 **(figure 3).**

La distance d4 est telle que $1 \leq d4 < d1$.

En **figure 3,** on considère le cas où d4=1. Dans ce cas, des connexions locales (ou « connexions horizontales locales ») L1 et L2 sont par exemple présentes respectivement entre les cellules M7 et M8, d'une part, et entre les cellules M8 et M9, d'autre part. Par souci de clarté, les autres connexions locales L reliant chaque autre paire de cellules M n'ont pas été représentées sur la figure 3.

Les connexions locales L permettent avantageusement d'optimiser le parcours nécessaire pour connecter ensemble deux blocs fonctionnels F, et donc de réduire encore davantage les temps de propagation dans le dispositif d'interconnexion programmable.

Si l'on reprend l'exemple évoqué ci-dessus, l'interconnexion entre les blocs fonctionnels $F_6$ et $F_{12}$ peut être réalisé en configurant les cellules $M_8$, $M_9$ et $M_{10}$ de façon à relier ensemble successivement : la connexion transverse B8-1, les deux connexions locales situées entre $M_8$ et $M_9$, et entre $M_9$ et $M_{10}$, et la connexion transverse B10-5 reliant physiquement la cellule $M_{10}$ et le bloc fonctionnel $F_{12}$. Cette configuration alternative permet de réduire les temps de propagation des signaux entre les blocs $F_6$ et $F_{12}$ par rapport au parcours décrit ci-avant faisant intervenir la connexion horizontale H2.

Le choix particulier de d4=1 permet avantageusement de simplifier l'algorithme de programmation du réseau d'interconnexion du dispositif 6. Ce choix permet notamment d'éviter des allers retours indésirables dans la rangée RM1 qui pourraient s'avérer nécessaires pour interconnecter ensemble deux blocs fonctionnels lorsque d4>1 (avec toujours d4<d1).

L'ajout des connexions locales L offrent en outre davantage de flexibilité au routage des interconnexions dans le dispositif puisque plusieurs options de routage sont alors possibles.

La déposante a constaté que les configurations suivantes permettent d'obtenir des performances optimales :

- d1 = 5, d2 = d3 = 2, d4 = 1 ; ou
- d1 = 7, d2 = d3 = 3, d4 = 1.

Comme indiqué précédemment, le dispositif d'interconnexion programmable 6 peut comprendre une pluralité de rangées de cellules M et une pluralité de rangées de blocs fonctionnels F, chaque rangée de F étant positionnée entre deux rangées de M. Autrement dit, pour p rangées de blocs F, le dispositif 6 comprend p+1 rangées de cellules M situées en alternance entre chaque rangée de blocs F (p étant un entier tel que p>1).

La **figure 4** représente un exemple où le dispositif d'interconnexion programmable 6 comprend à présent une rangée additionnelle RF2 de blocs fonctionnels F et deux rangées additionnelles RM2 et RM3 de cellules d'interconnexion programmables M. Par souci de clarté, le dispositif d'interconnexion programmable est renommé 8.

Les rangées RM1, RM2 et RM3 sont disposées en alternance de façon à ce que chaque rangée de blocs F soit placée entre deux rangées de cellules M. On pourrait toutefois imaginer qu'il y ait par exemple autant de rangées de blocs F que de rangées de cellules M.

Chacune des rangées RM2 et RM3 comprend des connexions horizontales H et des connexions locales L identiques à celles décrites ci-avant en référence à la rangée RM1. Comme déjà expliqué précédemment, l'inclusion des connexions locales L n'est toutefois pas obligatoire.

De plus, des faisceaux de connexions transverses B tels que décrits ci-avant en référence à la figure 3 sont présents entre chaque cellule M et la ou les rangées adjacentes de blocs fonctionnels F.

Par souci de clarté, seules les connexions reliant des cellules d'interconnexion programmables et des blocs fonctionnels de rang 8 ont été représentées sur la figure. On constate par exemple que les cellules M de la rangée RM2 sont reliées via deux faisceaux de connexions transverses B à des blocs fonctionnels situés respectivement dans les deux rangées adjacentes RF1 et RF2.

Par ailleurs, dans le cas particulier où il y a une pluralité de rangées de cellules d'interconnexion programmables (comme c'est le cas par exemple en figure 4), le dispositif 6 peut en outre comprendre une pluralité de connexions V dites verticales reliant chaque cellule d'interconnexion programmable Mj d'une rangée avec les cellules Mj correspondantes d'une rangée adjacente. Il est ainsi possible d'interconnecter entre elles deux à deux toutes les cellules Mj de même rang situées dans les différentes rangées de cellules d'interconnexion programmables.

En **figure 4** par exemple, la cellule $M_8$ de la rangée RM2 est relié physiquement aux cellules de même rang des rangées RM1 et RM2 via respectivement les connexions verticales V1 et V2. Chaque cellule $M_j$ de la rangée RM2 est ainsi reliée aux cellules correspondantes $M_j$ des rangées adjacentes RM1 et RM2 via des connexions verticales analogues (non représentées sur la figure par souci de clarté).

La structure de dispositif décrite ici peut ainsi s'appliquer pour un très grand nombre de rangées et pour un nombre très important de cellules M et de blocs fonctionnels F par rangée. Les valeurs des paramètres d1, d2, d3 (éventuellement d4), n et g ainsi que les nombres de rangées de cellules M et de blocs fonctionnels F peuvent être adaptés selon les besoins propres à chaque application.

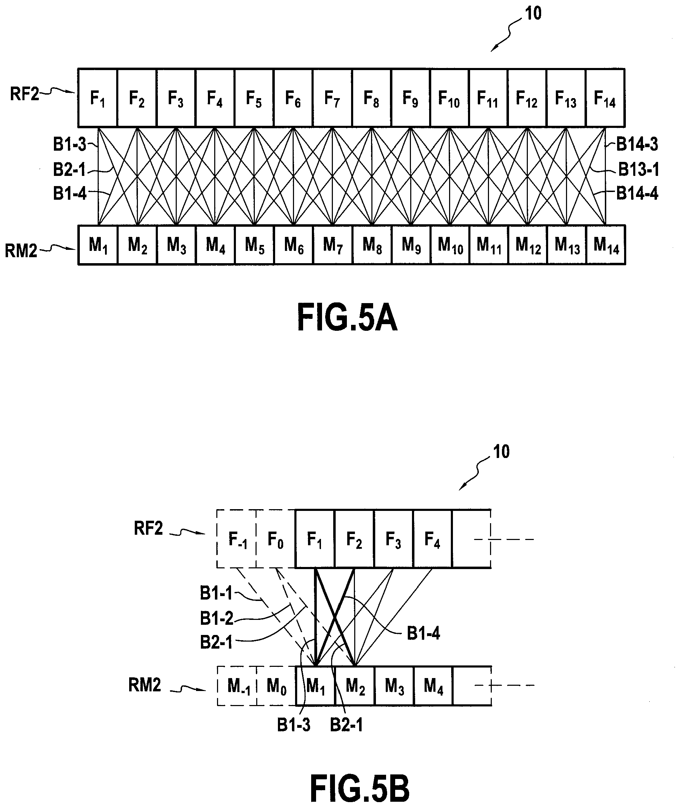

A titre d'exemple, les **figures 5A et 5B** représentent schématiquement l'ensemble des connexions transverses reliant physiquement les blocs fonctionnels F de la rangée RF2 et les cellules d'interconnexion programmables M de la rangée RM2 du dispositif 6. Comme indiqué précédemment, certaines connexions transverses B sont absentes aux deux extrémités de cette structure (notée 10).

Plus précisément, dans la mise en oeuvre particulière envisagée ici, chaque faisceau de connexions B relie au moyen de connexions transverses B une cellule d'interconnexion programmable $M_j$ respective de la rangée RM2 avec respectivement chacun des blocs fonctionnels $F_{j-d2}$ à $F_{j+d3}$ (j allant de 1 à n) de la rangée RF2 ou, le cas échéant, avec seulement ceux parmi ces blocs qui existent. En ce qui concerne les cellules $M_1$ à $M_{d2-1}$ et les cellules $M_{g-d3+1}$ à $M_g$, un ou plusieurs blocs fonctionnels parmi $F_{j-d2}$ à $F_{j+d3}$ n'existent pas.

Dans le cas particulier où d2=d3=2 et n=g=14, les faisceaux de connexions B issues des cellules $M_1$, $M_2$, $M_{13}$ et $M_{14}$ sont partiellement tronquées en raison de l'absence de blocs fonctionnels à gauche de $F_1$ et à droite de $F_{14}$. La **figure 5B** représente par exemple en pointillés :

- les blocs fonctionnels $F_{-1}$ et $F_0$ qui manquent à gauche du bloc $F_1$ ;
- les connexions transverses B1-1 et B1-2 qui devraient théoriquement relier $M_1$ à $F_{-1}$ et $F_0$ respectivement ;
- la connexion transverse B2-1 qui devrait théoriquement relier $M_2$ à $F_0$.

Dans une variante particulière où d2=d3, le dispositif peut comprendre en outre :

- une première connexion transverse additionnelle combinée à chacune des connexions transverses B reliant respectivement les cellules d'interconnexion programmables $M_j$ et les blocs fonctionnels $F_i$, pour chaque couple [i, j] avec i et j allant chacun de 1 à d2 sauf lorsque (d2 + 1 - i) < j, et
- une deuxième connexion transverse additionnelle combinée à chacune des connexions transverses reliant respectivement les cellules d'interconnexion programmables $M_j$ et les blocs fonctionnels $F_i$, pour chaque couple [i, j] avec i et j allant chacun de n-d3+1 à n sauf lorsque (d3 - 1 - n + i) < (n - j),

de sorte qu'un nombre constant de connexion transverses B relie toutes les cellules d'interconnexion programmables M de la deuxième rangée aux blocs fonctionnels de la première rangée.

Dans le cas par exemple de la **figure 5B,** il manque deux connexions transverses (B1-1 et B1-2) reliées à la cellule $M_1$ et une connexion transverse (B2-1) reliée à la cellule $M_2$. Aussi, il est avantageux d'ajouter deux connexions transverses supplémentaires à la cellule $M_1$ et une connexion transverse supplémentaire à la cellule $M_2$ afin de maintenir un nombre total constant de 5 connexions transverses attribuées à chaque cellule M de la rangée RM2. On tire ainsi avantageusement partie de toutes les entrées et sorties des cellules $M_1$ et $M_2$ qui étaient initialement non utilisées du fait de l'absence de $F_{-1}$ et $F_0$.

Dans une mise en oeuvre particulière, les connexions transverses B1-3 et B1-4 reliées à la cellule $M_1$ et la connexion transverse B2-1 reliée à la cellule $M_2$ sont doublées. Autrement dit, une connexion transverse additionnelle est ajoutée à chacune des connexions transverses B1-3, B1-4 et B2-1. Un doublage analogue des connexions transverses peut être réalisé à l'autre extrémité de la structure 10.

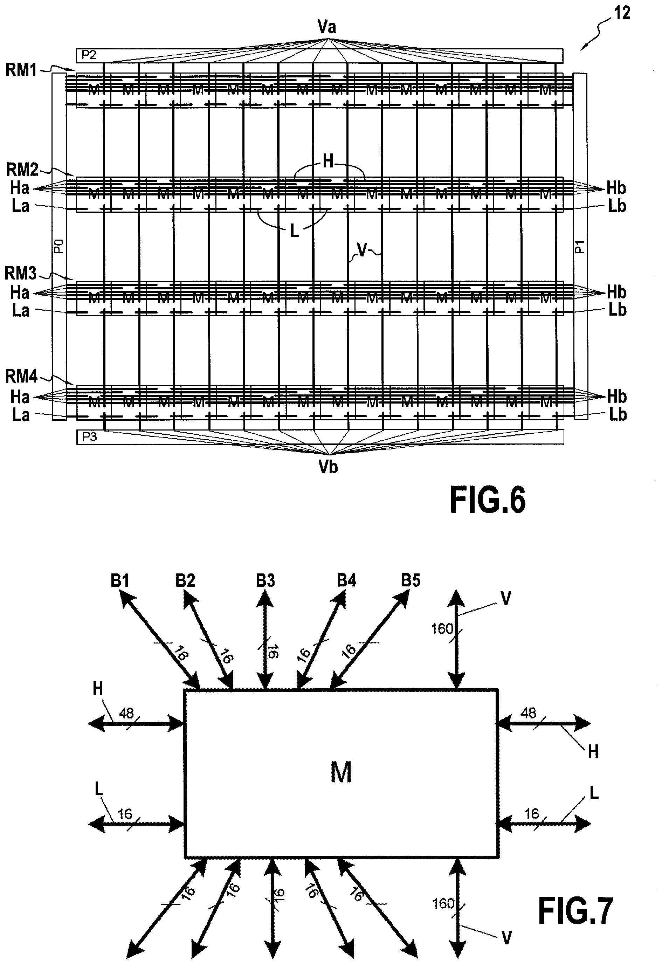

La **figure 6** représente l'exemple d'une structure 12 comprenant 4 rangées (notées respectivement RM1, RM2, RM3 et RM4) de cellules d'interconnexion programmables M disposées en alternance avec 3 rangées de blocs fonctionnels F. Par souci de clarté, les rangées de blocs F et les connexions transverses B n'ont pas été représentées sur cette figure bien qu'elles existent en pratique.

Dans le cas représenté en figure 6, les paramètres suivants ont été choisis :

-   d1=5
-   d4=1
-   n=g=14

La **figure 6** représente l'ensemble des connexions horizontales H, des connexions locales L et des connexions verticales V reliant entre elles les cellules d'interconnexion programmables M de la structure 12 (bien que les connexions L et, le échéant les connexions V, ne soient pas obligatoires comme déjà indiqué précédemment).

La structure 12 comprend en outre, pour chaque rangée de cellules M, des connexions horizontales additionnelles Ha et Hb reliant les cellules M situées aux extrémités de la rangée avec des blocs périphériques P0 et P1.

Dans une mise en oeuvre particulière, les cellules $M_1$ à $M_{d1-1}$ sont chacune reliées par une connexion horizontale additionnelle respective Ha avec le bloc périphérique voisin P0. De même, les cellules $M_{n-d1+1}$ à $M_n$ sont chacune reliées par une connexion horizontale additionnelle respective Hb avec le bloc périphérique voisin P1.

De plus, la structure 12 peut comprendre en outre deux connexions locales additionnelles La et Lb reliant respectivement les cellules $M_1$ et $M_n$ de chaque rangée avec les blocs périphériques respectifs P0 et P1.

La structure 12 peut également comprendre deux connexions verticales additionnelles Va et Vb reliant respectivement chaque cellule M de la rangée RM1 à un bloc périphérique voisin P2, et chaque cellule M de la rangée RM4 à un bloc périphérique voisin P3.

Dans un mode de réalisation particulier, chacune des connexions transverses comprend deux fils de connexion permettant respectivement la communication d'une sortie d'une cellule d'interconnexion programmable vers une entrée d'un bloc fonctionnel, d'une part, et la communication d'une sortie dudit bloc fonctionnel vers une entrée de ladite cellule d'interconnexion programmable, d'autre part.

La **figure 7** représente un exemple de configuration des connexions d'une cellule d'interconnexion programmable M et d'un bloc fonctionnel F. Dans ce cas, les connexions H comportent chacune 48 fils de connexion montante et 48 fils de connexion descendante, c'est-à-dire :

-   48 fils de connexions reliant 48 entrées d'une cellule M à 48 sorties d'une autre cellule M située à une distance d1, et
-   48 fils de connexions reliant 48 sorties d'une cellule M à 48 entrées d'une autre cellule M située à une distance d1.

De même, les connexions additionnelles L comportent chacune 16 fils de connexion montante et 16 fils de connexion descendante. Les connexions additionnelles V comportent chacune 160 fils de connexion montante et 160 fils de connexion descendante. Les connexions transverses B1 à B10 (dans le cas où (1+d2+d3)=5) possèdent chacune 16 fils de connexion montante et 16 fils de connexion descendante.

Comme déjà indiqué précédemment, chaque bloc fonctionnel F du dispositif d'interconnexion programmable selon l'invention comprend des circuits électroniques permettant de réaliser des fonctions logiques. Un bloc F peut prendre la forme d'un bloc fonctionnel logique programmable ou toute autre forme plus adaptée à la réalisation de la ou des fonctions souhaitées. Des exemples de structure de blocs fonctionnels au sens de l'invention sont à présent brièvement décrits en référence aux **figures 8A à 8D**.

Comme déjà expliqué, chaque bloc fonctionnel peut comprendre :

-   une pluralité d'entrées,
-   une pluralité de sorties,
-   une pluralité de fonctions électroniques numériques, et
-   un réseau d'interconnexion programmable apte à interconnecter entre elles les entrées et les sorties desdites fonctions électroniques numériques.

Dans les exemples envisagés dans ce document, chaque bloc fonctionnel F est apte à permuter ses entrées entre elles et est également apte à permuter ses sorties entre elles.

Dans un mode particulier, les blocs fonctionnels F du dispositif d'interconnexion programmable de l'invention comprennent chacun un réseau d'interconnexion programmable permettant de réaliser des connexions par programmation entre les entrées, les sorties et les fonctions numériques dudit bloc fonctionnel.

La **figure 8A** représente un premier exemple de structure (notée 14) d'un bloc fonctionnel, cette structure 14 comportant :

- un ensemble de f blocs logiques BL repérés chacun par un rang allant de 1 à f, chaque bloc logique comportant m entrées I repérées chacune par un rang différent allant de 1 à m et o sorties O repérées chacune par un rang différent allant de 1 à o. Les f blocs logiques BL permettent de réaliser les fonctions combinatoires et/ou séquentielles d'un schéma donné.
- un ensemble de e entrées E repérées chacune par un rang différent allant de 1 à e ;
- un ensemble de s sorties S repérées chacune par un rang différent allant de 1 à s ; et
- un réseau d'interconnexion programmable R permettant de réaliser les connexions entre les f blocs logiques, les e entrées E et les s sorties S.

La figure 8A représente le cas particulier où : e=s=160, f=384, m=4 et o=1. Dans cet exemple, les 4 entrées du bloc logique BL1 sont notées I1 à I4 et la sortie de BL1 est notée O1.

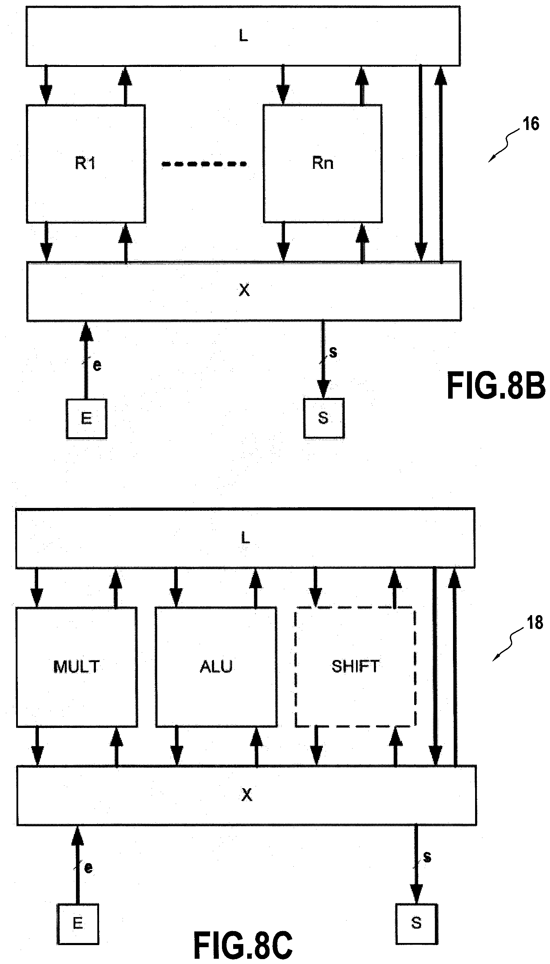

La **figure 8B** représente un deuxième exemple de structure (notée 16) d'un bloc fonctionnel, cette structure 16 comportant :

- un ensemble S de s sorties ;
- un ensemble E de e entrées ;
- un ensemble de n fonctions R de type mémoire statique (SRAM) notées de R1 à Rn, ces fonctions possédant un ou plusieurs ports de lecture et d'écriture ;
- une fonction logique L comprenant des portes logiques et des registres ;
- un réseau de crossbars X ;
- des interconnexions entres les fonctions SRAM R et la fonction logique L ;
- des interconnexions entre les fonctions SRAM R et le réseau de crossbars X;
- des interconnexions entre la fonction logique L et le réseau de crossbars X;
- des interconnexions entres les entrées E et le réseau de crossbars X ; et
- des interconnexions entre les sorties S et le réseau de crossbars X.

Les entrées E et les sorties S sont connectées au réseau de cellules d'interconnexion programmables M.

La **figure 8C** représente un troisième exemple de structure (notée 18) d'un bloc fonctionnel, cette structure 18 comportant :

- un ensemble S de s sorties ;
- un ensemble E de e entrées ;
- au moins une fonction MULT de type multiplieur ;
- au moins une fonction ALU de type arithmétique et logique pouvant réaliser des opérations nécessitant une propagation de retenue ou des opérations booléennes sur des opérandes de largeur supérieure à 1 ;
- éventuellement, des fonctions additionnelles telles qu'une fonction SHIFT de décalage arithmétique ou logique ;
- une fonction logique L comprenant des portes logiques et des registres ;
- un réseau de crossbars X ;
- des interconnexions entres les fonctions MULT, ALU, SHIFT et la fonction logique L ;
- des interconnexions entre les fonctions MULT, ALU, SHIFT et le réseau de crossbars X ;
- des interconnexions entre la fonction logique L et le réseau de crossbars X;
- des interconnexions entres les entrées E et le réseau de crossbars X ; et
- des interconnexions entre les sorties S et le réseau de crossbars X.

Les entrées E et les sorties S sont connectées au réseau de cellules d'interconnexion programmables M.

La **figure 8D** représente un quatrième exemple de structure (notée 20) d'un bloc fonctionnel, cette structure 18 comportant :

- un ensemble S de s sorties ;
- un ensemble E de e entrées ;
- éventuellement, un ensemble XE d'entrées dédiées (connexions différentes des connexions horizontales, verticales et locales décrites précédemment) ;
- éventuellement, un ensemble XS de sorties dédiées (connexions différentes des connexions horizontales, verticales et locales décrites précédemment) ;
- une fonction logique L comprenant des portes logiques et des registres réalisant un traitement numérique des signaux provenant des entrées E et XE, cette fonction logique L générant un résultat qu'elle envoie via des signaux sur les sorties S et XS ;
- un réseau de crossbars X ;
- des interconnexions entre la fonction logique L et le réseau de crossbars X;
- des interconnexions entre la fonction logique L et les entrées dédiées XE ;
- des interconnexions entre la fonction logique L et les sorties dédiées XS ;
- des interconnexions entres les entrées E et le réseau de crossbars X ; et
- des interconnexions entre les sorties S et le réseau de crossbars X.

Les entrées E et les sorties S sont connectées au réseau de cellules d'interconnexion programmables M. Les entrées XE et les sorties XS sont connectées à toute autre partie du circuit intégré.

Un homme du métier comprendra que les modes de réalisation et variantes décrits ci-avant ne constituent que des exemples non limitatifs de mise en oeuvre de l'invention. En particulier, l'homme du métier pourra envisager une quelconque combinaison des variantes et modes de réalisation décrits ci-avant afin de répondre à un besoin bien particulier.

La présente invention concerne également un composant FPGA comprenant un dispositif d'interconnexion programmable au sens de l'invention, par exemple selon l'un des modes de réalisations ou variantes décrits ci-avant.

**Revendications**

1. Dispositif d'interconnexion programmable (6 ; 8) comprenant :

   - au moins une première rangée (RF1, RF2) de g blocs fonctionnels ($F_1$-$F_{14}$), chaque bloc fonctionnel comprenant une pluralité d'entrées, une pluralité de sorties et une pluralité de fonctions numériques ;
   - au moins une deuxième rangée (RM1, RM2, RM3) de n cellules ($M_1$-$M_{14}$) d'interconnexion programmables, ladite deuxième rangée étant adjacente à ladite première rangée ; et
   - une pluralité de faisceaux de connexions, chaque faisceau comportant au moins deux connexions (B) dites transverses reliant une même cellule ($M_8$) d'interconnexion programmable avec respectivement un ensemble de blocs fonctionnels ($F_6$-$F_{10}$) de la première rangée (RF1, RF2) adjacents entre eux dont l'un des blocs est situé en correspondance avec ladite cellule ;
   dans lequel l'ensemble des cellules ($M_1$-$M_{14}$) d'interconnexion programmables sont aptes à interconnecter entre elles les entrées et les sorties de chaque bloc fonctionnel ($F_1$-$F_{14}$) de ladite première rangée (RF1, RF2) avec respectivement les sorties et les entrées de tous les autres blocs fonctionnels de ladite première rangée au moyen desdites connexions horizontales (H) et transverses (B) ;

   ledit dispositif d'interconnexion programmable étant **caractérisé en ce qu'**il comprend en outre :

   - une pluralité de connexions (H) dites horizontales, chaque connexion horizontale reliant une cellule ($M_8$) d'interconnexion programmable respective de la deuxième rangée (RM1, RM2, RM3) avec uniquement une autre cellule ($M_3$;

$M_{13}$) d'interconnexion programmables de ladite deuxième rangée, lesdites cellules reliées ensemble par ladite connexion horizontale (H) n'étant pas adjacentes l'une vis-à-vis de l'autre dans la deuxième rangée.

2. Dispositif selon la revendication 1, dans lequel n = g.

3. Dispositif selon la revendication 2, dans lequel :

   - les blocs fonctionnels dits $F_i$ de la première rangée sont tels que chaque $F_i$ est disposé de façon à être adjacent à $F_{i-1}$ et $F_{i+1}$, i étant un entier naturel allant de 1 à g ;
   - les cellules d'interconnexion programmables dites $M_j$ de la deuxième rangée sont telles que chaque $M_j$ est disposée de façon à être adjacente à $M_{j-1}$ et $M_{j+1}$, j étant un entier allant de 1 à n, dans lequel $M_j$ et $F_i$ sont positionnés en vis-à-vis l'un de l'autre lorsque i=j ;
   - chaque connexion horizontale (H) relie une cellule d'interconnexion programmable $M_j$ respective de la deuxième rangée avec uniquement la cellule d'interconnexion programmable voisine $M_{j+d1}$ de ladite deuxième rangée pour j allant de 1 à n-d1 ;
   - chaque faisceau relie au moyen des connexions transverses (B) une cellule d'interconnexion programmable $M_j$ respective de ladite deuxième rangée avec respectivement chacun des blocs fonctionnels $F_{j-d2}$ à $F_{j+d3}$ de ladite première rangée ou, le cas échéant, avec seulement ceux parmi ces blocs qui existent ; et
   - d1, d2 et d3 sont des entiers tels que : $d2 \geq 1$, $d3 \geq 1$, $1 < d1 \leq d2 + d3 + 1$ et $g > d2 + d3$.

4. Dispositif selon la revendication 3, dans lequel d1 = 2, d2 = d3 = 1.

5. Dispositif selon la revendication 3, comprenant une pluralité de connexions (L) dite locales reliant une cellule d'interconnexion $M_j$ respective de ladite deuxième rangée avec uniquement la cellules d'interconnexion $M_{j+d4}$ de la deuxième rangée pour j allant de 1 à n-d4, d4 étant tel que $1 \leq d4 < d1$.

6. Dispositif selon la revendication 5, dans lequel d1 = 5, d2 = d3 = 2 et d4 = 1.

7. Dispositif selon la revendication 5, dans lequel d1 = 7, d2 = d3 = 3 et d4 = 1.

8. Dispositif selon l'une quelconque des revendications 2 à 7, comprenant une pluralité de dites premières et deuxièmes rangées disposées en alternance, le dispositif comprenant en outre une pluralité de connexions (V) dites verticales reliant chaque cellule d'interconnexion programmable $M_j$ d'une première

rangée avec les cellules $M_j$ correspondantes d'une première rangée adjacente.

9. Dispositif selon la revendication 8, dans lequel d2 = d3, le dispositif comprenant :

> - une première connexion transverse additionnelle combinée à chacune desdites connexions transverses reliant respectivement les cellules d'interconnexion programmables $M_j$ et les blocs fonctionnels $F_i$, pour chaque couple [i, j] avec i et j allant chacun de 1 à d2 sauf lorsque (d2 + 1 - i) < j, et
> - une deuxième connexion transverse additionnelle combinée à chacune desdites connexions transverses reliant respectivement les cellules d'interconnexion programmables $M_j$ et les blocs fonctionnels $F_i$, pour chaque couple [i, j] avec i et j allant chacun de n-d3+1 à n sauf lorsque (d3 - 1 - n + i) < (n - j),

> de sorte qu'un nombre constant de connexion transverses relie toutes les cellules d'interconnexion programmables de la deuxième rangée aux blocs fonctionnels de la première rangée.

10. Dispositif selon l'une quelconque des revendications 1 à 9, dans lequel les blocs fonctionnels comprennent chacun un réseau d'interconnexion programmable (R) permettant de réaliser des connexions par programmation entre les entrées, les sorties et les fonctions numériques dudit bloc fonctionnel.

11. Dispositif selon l'une quelconque des revendications 1 à 10, dans lequel chacune desdites connexions comprend deux fils de connexion permettant respectivement la communication d'une sortie d'une première cellule d'interconnexion programmable vers une entrée d'un bloc fonctionnel ou d'une deuxième cellule d'interconnexion programmable, d'une part, et la communication d'une sortie dudit bloc fonctionnel ou de ladite deuxième cellule d'interconnexion programmable vers une entrée de ladite première cellule d'interconnexion programmable, d'autre part.

12. Composant FPGA comprenant un dispositif d'interconnexion programmable selon l'une quelconque des revendications 1 à 11.

**Patentansprüche**

1. Programmierbare Verbindungsvorrichtung (6; 8), umfassend:

> - mindestens eine erste Reihe (RF1, RF2) von g Funktionsblöcken ($F_1$-$F_{14}$), wobei jeder Funktionsblock eine Vielzahl von Eingängen, eine Vielzahl von Ausgängen und eine Vielzahl von digitalen Funktionen umfasst,
> - mindestens eine zweite Reihe (RM1, RM2, RM3) von n programmierbaren Verbindungszellen ($M_1$-$M_{14}$), wobei die zweite Reihe an die erste Reihe angrenzt, und
> - eine Vielzahl von Anschlussbündeln, wobei jedes Bündel mindestens zwei so genannte Queranschlüsse (B) umfasst, die eine selbe programmierbare Verbindungszelle ($M_8$) mit jeweils einer Gesamtheit von aneinander grenzenden Funktionsblöcken ($F_6$-$F_{10}$) der ersten Reihe (RF1, RF2) verbindet, von denen einer der Blöcke in Übereinstimmung mit der Zelle angeordnet ist,

bei der die Gesamtheit der programmierbaren Verbindungszellen ($M_1$-$M_{14}$) geeignet ist, die Eingänge und die Ausgänge jedes Funktionsblocks ($F_1$-$F_{14}$) der ersten Reihe (RF1, RF2) jeweils mit den Ausgängen und Eingängen aller anderen Funktionsblöcke der ersten Reihe mit Hilfe der Horizontal- (H) und Queranschlüsse (B) miteinander zu verbinden, wobei die Verbindungsvorrichtung **dadurch gekennzeichnet ist, dass** sie ferner umfasst:

> - eine Vielzahl von so genannten Horizontalanschlüssen (H), wobei jeder Horizontalanschluss eine jeweilige programmierbare Verbindungszelle ($M_8$) der zweiten Reihe (RM1, RM2, RM3) mit nur einer anderen programmierbaren Verbindungszelle ($M_3$; $M_{13}$) der zweiten Reihe verbindet, wobei die miteinander durch den Horizontalanschluss (H) verbundenen Zellen in der zweiten Reihe nicht gegenüberliegend aneinander angrenzen.

2. Vorrichtung gemäß Anspruch 1, bei der n = g.

3. Vorrichtung gemäß Anspruch 2, bei der:

> - die Funktionsblöcke $F_i$ der ersten Reihe derart sind, dass jeder $F_i$ derart angeordnet ist, dass er an $F_{i-1}$ und $F_{i+1}$ angrenzt, wobei i eine natürliche ganze Zahl von 1 bis g ist,
> - die programmierbaren Verbindungszellen $M_j$ der zweiten Reihe derart sind, dass $M_j$ derart angeordnet ist, dass sie an $M_{j-1}$ und $M_{j+1}$ angrenzt, wobei j eine ganze Zahl von 1 bis n ist, und wobei $M_j$ und $F_i$ einander gegenüber angeordnet sind, wenn i = j,
> - jeder Horizontalanschluss (H) eine jeweilige programmierbare Verbindungszelle $M_j$ der zweiten Reihe nur mit der benachbarten programmierbaren Verbindungszelle $M_{j+d1}$ der zweiten Reihe verbinden, wobei j von 1 bis n-d1 geht,
> - jedes Bündel mit Hilfe der Queranschlüsse (B) eine jeweilige programmierbare Verbindungszelle $M_j$ der zweiten Reihe mit jeweils jedem der Funktionsblöcke $F_{j-d2}$ bis $F_{j+d3}$ der ersten Reihe oder gegebenenfalls nur mit jenen unter diesen Blöcken, die vorhanden sind, verbindet, und

- d1, d2 und d3 ganze Zahlen sind, so dass: d2 $\geq$ 1, d3 $\geq$ 1, 1 < d1 $\leq$ d2 +d3 +1 und g > d2 + d3.

4. Vorrichtung gemäß Anspruch 3, bei der d1 = d2, d2 = d3 = 1.

5. Vorrichtung gemäß Anspruch 3, umfassend eine Vielzahl von so genannten lokalen Anschlüssen (L), die eine jeweilige Verbindungszelle $M_j$ der zweiten Reihe nur mit der Verbindungszelle $M_{j+d4}$ der zweiten Reihe verbinden, wobei j von 1 bis n-d4 geht, wobei d4 derart ist, dass 1 $\leq$ d4 < d1.

6. Vorrichtung gemäß Anspruch 5, bei der d1 = 5, d2 = d3 = 2 und d4 = 1.

7. Vorrichtung gemäß Anspruch 5, bei der d1 = 7, d2 = d3 = 3 und d4 = 1.

8. Vorrichtung gemäß einem der Ansprüche 2 bis 7, umfassend eine Vielzahl sogenannter erster und zweiter Reihen, die alternierend angeordnet sind, wobei die Vorrichtung ferner eine Vielzahl von so genannten Vertikalanschlüssen (V) umfasst, die jede programmierbare Verbindungszelle $M_j$ einer ersten Reihe mit den entsprechenden Zellen $M_j$ einer angrenzenden ersten Reihe verbinden.

9. Vorrichtung gemäß Anspruch 8, bei der d2 = d3, wobei die Vorrichtung umfasst:

- einen ersten zusätzlichen Queranschluss, der mit jedem der Queranschlüsse kombiniert ist und die programmierbaren Verbindungszellen $M_j$ und die Funktionsblöcke $F_i$ für jedes Paar [i, j] verbindet, wobei i und j jeweils von 1 bis d2 gehen, außer wenn (d2 + 1 - i) < j, und
- einen zweiten zusätzlichen Queranschluss, der mit jedem der Queranschlüsse kombiniert ist, die die programmierbaren Verbindungszellen $M_j$ und die Funktionsblöcke $F_i$ für jedes Paar [i, j] verbinden, wobei i und j jeweils von n-d3+1 bis n gehen, außer wenn (d3 - 1 - n + i) < (n -j),

so dass eine konstante Anzahl von Queranschlüssen alle programmierbaren Verbindungszellen der zweiten Reihe mit den Funktionsblöcken der ersten Reihe verbindet.

10. Vorrichtung gemäß einem der Ansprüche 1 bis 9, bei der die Funktionsblöcke jeweils ein programmierbares Verbindungsnetz (R) umfassen, das es ermöglicht, Anschlüsse durch Programmierung zwischen den Eingängen, den Ausgängen und den digitalen Funktionen des Funktionsblocks herzustellen.

11. Vorrichtung gemäß einem der Ansprüche 1 bis 10, bei der jeder der Anschlüsse zwei Anschlussadern umfasst, die die Verbindung eines Ausgangs einer ersten programmierbaren Verbindungszelle zu einem Eingang eines Funktionsblocks oder einer zweiten programmierbaren Verbindungszelle einerseits bzw. die Verbindung eines Ausgangs des Funktionsblocks oder der zweiten programmierbaren Verbindungszelle zu einem Eingang der ersten programmierbaren Verbindungszelle andererseits ermöglicht.

12. FPGA-Komponente, umfassend eine programmierbare Verbindungsvorrichtung gemäß einem der Ansprüche 1 bis 11.

**Claims**

1. A programmable interconnect device (6; 8), comprising:

- at least a first row (RF1, RF2) of g functional blocks ($F_1$-$F_{14}$), each functional block comprising a plurality of inputs, a plurality of outputs and a plurality of digital functions;
- at least a second row (RM1, RM2, RM3) of n programmable interconnect cells ($M_1$-$M_{14}$), said second row being adjacent to said first row; and
- a plurality of bundles of connections, each bundle comprising at least two so-called transverse connections (B) connecting a same programmable interconnect cell ($M_8$) respectively with a set of functional blocks (F6-F10) of the first row (RF1, RF2) adjacent to one another whereof one of the blocks is situated to match said cell;

wherein the set of programmable interconnect cells ($M_1$-$M_{14}$) is able to interconnect the inputs and the outputs of each functional block ($F_1$-$F_{14}$) of said first row (RF1, RF2) to one another respectively with the outputs and the inputs of all of the other functional blocks of said first row using said horizontal (H) and transverse (B) connections; said programmable interconnect device being **characterized in that** it further comprises:

- a plurality of so-called horizontal connections (H), each horizontal connection connecting a respective programmable interconnect cell ($M_8$) of the second row (RM1, RM2, RM3) with only one other programmable interconnect cell ($M_3$; $M_{13}$) of said second row, said cells connected to one another by said horizontal connection (H) not being adjacent to one another in the second row.

2. The device according to claim 1, wherein n = g.

3. The device according to claim 2, wherein:

- the functional blocks, called $F_i$, of the first row are such that each $F_i$ is arranged so as to be adjacent to $F_{i-1}$ and $F_{i+1}$, i being a natural number from 1 to g;
- the programmable interconnect cells, called $M_j$, of the second row are such that each $M_j$ is arranged so as to be adjacent to $M_{j-1}$ and $M_{j+1}$, j being an integer from 1 to n, wherein $M_j$ and $F_i$ are positioned across from one another when i=j;
- each horizontal connection (H) connects a respective programmable interconnect cell $M_j$ of the second row with only the adjacent programmable interconnect cell $M_{j+d1}$ of said second row for j going from 1 to n-d1;
- each bundle connects, using the transverse connections (B), a respective programmable interconnect cell $M_j$ of said second row respectively with each of the functional blocks $F_{j=d2}$ to $F_{j+d3}$ of said first row or, if applicable, with only those among the set blocks that exist; and
- d1, d2 and d3 are integers such that: $d2 \geq 1$, $d3 \geq 1$, $1 < d1 \leq d2 + d3 + 1$ and $g > d2 + d3$.

4. The device according to claim 3, wherein d1 = 2, d2 = d3 = 1.

5. The device according to claim 3, comprising a plurality of so-called local connections (L) connecting a respective interconnect cell $M_j$ of said second row with only the interconnect cells $M_{j+d4}$ of the second row for j going from 1 to n-d4, d4 being such that $1 \leq d4 < d1$.

6. The device according to claim 5, wherein d1 = 5, d2 = d3 = 2 and d4 = 1.

7. The device according to claim 5, wherein d1 = 7, d2 = d3 = 3 and d4 = 1.

8. The device according to any one of claims 2 to 7, comprising a plurality of said first and second rows arranged alternating, the device further comprising a plurality of so-called vertical connections (E) connecting each programmable interconnect cell $M_j$ of the first row with the corresponding cells $M_j$ of an adjacent first row.

9. The device according to claim 9, wherein d2 = d3, the device comprising:

- a first additional transverse connection combined with each of said transverse connections respectively connecting the programmable interconnect cells $M_j$ and the functional blocks $F_i$, for each pair [i, j] with i and j each going from 1 to d2 except when (d2 + 1 - i) < j, and
- a second additional transverse connection combined with each of said transverse connections respectively connecting said programmable interconnect cells $M_j$ and the functional blocks $F_i$, for each pair [i, j] with i and j each going from n-d3+1 to n except when (d3 - 1 - n + 1) < (n - j),

such that a constant number of transverse connections connects all of the programmable interconnect cells of the second row to the functional blocks of the first row.

10. The device according to any one of claims 1 to 9, wherein the functional blocks each comprise a programmable interconnect array (R) making it possible to produce connections by programming between the inputs, the outputs and the digital functions of said functional block.

11. The device according to any one of claims 1 to 10, wherein each of said connections comprises two connecting wires respectively allowing the communication from an output of a first programmable interconnect cell toward an input of a vfunctional block or of a second programmable interconnect cell, on the one hand, and the communication from an output of said functional block or said second programmable interconnect cell toward an input of said first programmable interconnect cell, on the other hand.

12. An FPGA comprising a programmable interconnect device according to any one of claims 1 to 11.

**FIG.1**
Art antérieur

**FIG.2**
Art antérieur

FIG.3

FIG.4

**FIG.5A**

**FIG.5B**

**FIG.6**

**FIG.7**

O1

BL 1    BL 2    — — — — — — —    BL 384

I1  I2  I3  I4

R

14

160    160

S    E

**FIG.8A**

XE    XS

L

20

X

e

E    s    S

**FIG.8D**

FIG.8B

16

FIG.8C

18

**EP 2 979 363 B1**

## RÉFÉRENCES CITÉES DANS LA DESCRIPTION

**Documents brevets cités dans la description**

- US 6289494 B1
- US 7028281 B1
- US 5742181 A
- US 6014509 A